# EUROPEAN PATENT APPLICATION

(11) **EP 3 142 155 A1**
(43) Date of publication of application: **15.03.2017**
(21) Application number: 16196706.2
(22) Date of filing: 28.11.2012
(51) Int. Cl.: H01L 31/04, H01L 31/032

(54) **PHOTOELECTRIC CONVERSION DEVICE**

(30) Priority: 27.01.2012 JP 2012014958; 26.07.2012 JP 2012166090
(62) Divisional of application: 12866731.8
(71) Applicant: Kyocera Corporation, Kyoto-shi, Kyoto-fu 612-8501 (JP)
(72) Inventor: MIYAMICHI, Yusuke, Kyoto-shi Kyoto, 612-8501 (JP); DOMOTO, Tatsuya, Kyoto-shi Kyoto, 612-8501 (JP); KAMADA, Rui, Kyoto-shi Kyoto, 612-8501 (JP); ASANO, Yuji, Kyoto-shi Kyoto, 612-8501 (JP); USHIO, Shinnosuke, Kyoto-shi Kyoto, 612-8501 (JP)
(74) Representative: Viering, Jentschura & Partner mbB Patent- und Rechtsanwälte

(57) **Abstract**

A photoelectric conversion efficiency of a photoelectric conversion device is improved.

A photoelectric conversion device 11 comprises an electrode layer 2, a first semiconductor layer 3 disposed on the electrode layer 2 and including a group I-III-VI compound and oxygen element, and a second semiconductor layer 4 disposed on the first semiconductor layer 3 and forming a pn junction with the first semiconductor layer 3.

## Description

### Technical Field

The present invention relates to a photoelectric conversion device including a group I-III-VI compound.

### Background Art

As a photoelectric conversion device to be used for solar photovoltaic power generation, a device using a group I-III-VI compound such as CIGS having a high optical absorption coefficient as a light absorbing layer is exemplified. Such a photoelectric conversion device is disclosed in, for example, Japanese Unexamined Patent Application Publication No. 8-330614. The group I-III-VI compound has a high optical absorption coefficient and is suitable for a reduction in the film thickness, an increase in area, and a reduction in cost of a photoelectric conversion device. Accordingly, research and development of the next-generation solar cells using the group I-III-VI compound have been promoted.

The photoelectric conversion device including such a group I-III-VI compound is formed by two-dimensionally arranging a plurality of photoelectric conversion cells, in which a lower electrode layer such as a metal electrode, a light-absorbing layer, a buffer layer, and a transparent conductive film are stacked in this order on a substrate such as glass. The plurality of photoelectric conversion cells are electrically connected in series by connecting the transparent conductive film of one of the adjacent photoelectric conversion cells and the lower electrode layer of the other of the adjacent photoelectric conversion cells through a connection conductor.

Improvement of photoelectric conversion efficiency is constantly demanded for the photoelectric conversion device including the group I-III-VI compound. The photoelectric conversion efficiency represents a ratio in which energy of solar light is converted into electric energy in the photoelectric conversion device, and is derived, for example, by dividing a value of the electric energy output from the photoelectric conversion device by a value of the energy of solar light incident to the photoelectric conversion device and then multiplying the divided value by 100.

### Summary of Invention

An object of the present invention is to improve photoelectric conversion efficiency of a photoelectric conversion device.

A photoelectric conversion device according to an embodiment of the present invention includes an electrode layer; a first semiconductor layer disposed on the electrode layer and including a group I-III-VI compound; and a second semiconductor layer disposed on the first semiconductor layer and forming a pn junction with the first semiconductor layer. The first semiconductor layer includes at least one of sulfur, selenium, and tellurium as group VI-B elements and oxygen. In addition, an atomic concentration of oxygen in the first semiconductor layer is lower in a surface portion on the electrode layer side than in a central portion of the first semiconductor layer in a thickness direction thereof.

According to the present invention, the photoelectric conversion efficiency in the photoelectric conversion device is improved.

### Brief Description of Drawings

Fig. 1 is a perspective view illustrating an example of a photoelectric conversion device according to an embodiment.
Fig. 2 is a cross-sectional view of the photoelectric conversion device illustrated in Fig. 1.
Fig. 3 is a graph illustrating distribution of oxygen concentration in a first semiconductor layer.
Fig. 4 is a graph illustrating a ratio of a gallium element to the total of the gallium element and an indium element of a first semiconductor layer in another example of the photoelectric conversion device.

### Description of Embodiments

Hereinafter, a photoelectric conversion device according to an embodiment of the present invention will be described in detail with reference to the drawings.

### <Configuration of photoelectric conversion device>

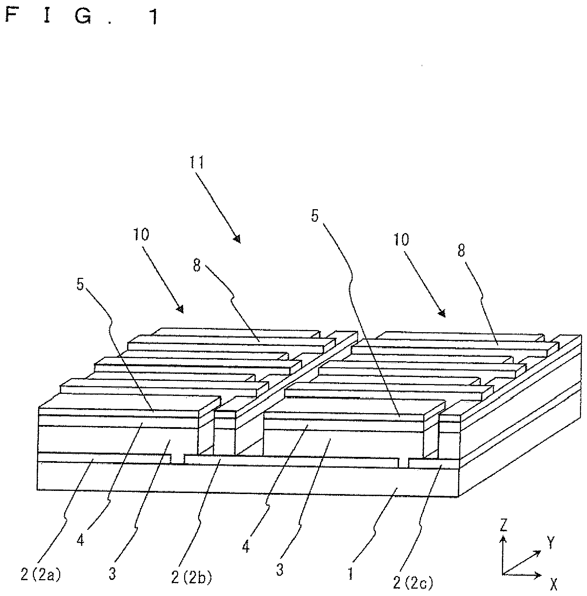

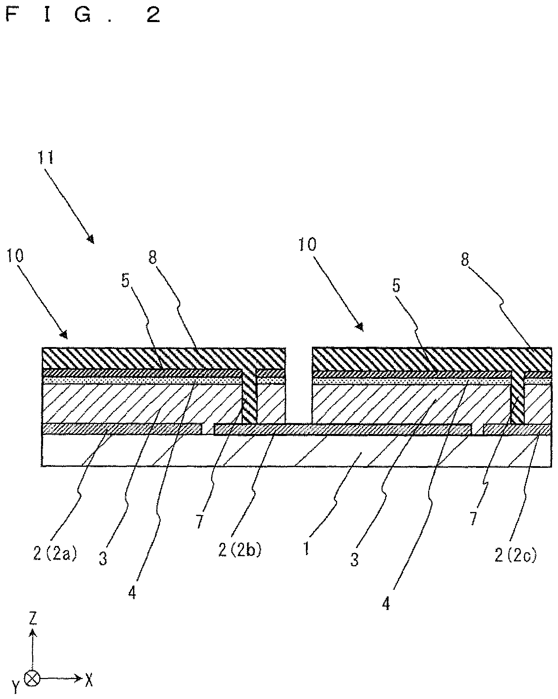

Fig. 1 is a perspective view illustrating an example of a photoelectric conversion device according to an embodiment of the present invention and Fig. 2 is an XZ cross-sectional view thereof. An XYZ coordinate system of a right-handed system using the arrangement direction (the left-right direction in Fig. 1) of photoelectric conversion cells 10 as the X-axis direction is given to Figs. 1 and 2. In a photoelectric conversion device 11, a plurality of photoelectric conversion cells 10 are arranged on a substrate 1 and are electrically connected to one another. Although only two photoelectric conversion cells 10 are illustrated in Fig. 1 for convenience of illustration, multiple photoelectric conversion cells 10 may be two-dimensionally arranged in the right-left direction (X-axis direction), and further in a direction (Y-axis direction) perpendicular to the right-left direction in the actual photoelectric conversional device 11.

In Figs. 1 and 2, a plurality of lower electrode layers 2 are two-dimensionally arranged on the substrate 1. In Figs. 1 and 2, the plurality of lower electrode layers 2 include lower electrode layers 2a to 2c arranged in one direction (X-axis direction) with a gap between them. A first semiconductor layer 3 is disposed over the lower electrode layer 2a and the lower electrode layer 2b through a portion on the substrate 1. In addition, a second semiconductor layer 4 whose conductivity type is different from that of the first semiconductor layer 3 is disposed on the first semiconductor layer 3. Further, a connection conductor 7 is disposed on the lower electrode layer 2b along the surface (side surface) of the first semiconductor layer 3 or by penetrating (dividing) the first semiconductor layer 3. The connection conductor 7 electrically connects the second semiconductor layer 4 and the lower electrode layer 2b. One photoelectric conversion cell 10 is formed of the lower electrode layer 2, the first semiconductor layer 3, and the second semiconductor layer 4, and a high-output photoelectric conversion device 11 is configured by connecting adjacent photoelectric conversion cells 10 in series through the connection conductor 7. In addition, in the photoelectric conversion device 11 in the present embodiment, it is assumed that light is incident from the second semiconductor layer 4 side, but without being limited thereto, light may be incident from the substrate 1 side.

The substrate 1 supports the photoelectric conversion cells 10. Examples of a material to be used for the substrate 1 include glass, ceramics, resins, metals, and the like. As the substrate 1, soda lime glass having a thickness of approximately 1 mm to 3 mm can be used.

The lower electrode layers 2 (lower electrode layers 2a, 2b, and 2c) are conductors such as Mo, Al, Ti, or Au disposed on the substrate 1. The lower electrode layers 2 are formed to have a thickness of approximately 0.2 µm to 1 µm using a known thin film forming method such as a sputtering method or a deposition method.

The first semiconductor layer 3 has a thickness of, for example, 1 µm to 3 µm and mainly includes a group I-III-VI compound. The group I-III-VI compound is a compound of group I-B elements (also referred to as group 11 elements), group III-B elements (also referred to as group 13 elements), and a chalcogen element. Note that, the chalcogen element is S, Se, or Te in group VI-B elements. Examples of the group I-III-VI compound include CuInSe₂ (copper indium diselenide, also referred to as CIS), Cu(In,Ga)Se₂ (copper indium gallium diselenide, also referred to as CIGS), and Cu(In,Ga)(Se,S)₂ (copper indium gallium diselenide disulfide, also referred to as CIGSS). Alternatively, the first semiconductor layer 3 may be formed of a multiple compound semiconductor thin film such as copper indium gallium diselenide provided with a thin copper indium gallium diselenide disulfide layer as a surface layer.

In addition, the first semiconductor layer 3 further includes an oxygen element, and the atomic concentration of the oxygen element is lower in the surface portion on the lower electrode layer 2 side than in the central portion of the first semiconductor layer 3 in the thickness direction (Z-axis direction). With such a configuration, the photoelectric conversion efficiency of the photoelectric conversion device 11 is improved. That is, it is possible to sufficiently reduce recombination of carriers by filling defects of the first semiconductor layer 3 with the oxygen element, since the oxygen element is contained in the first semiconductor layer 3, and possible to effectively suppress formation of a different phase with high resistance due to oxidation of the lower electrode layer 2, since the oxygen concentration is lower in the surface portion on the lower electrode layer 2 side of the first semiconductor layer 3. In addition, a position of the energy in a valence band of the first semiconductor layer 3 can be shifted to a negative potential side in the vicinity of the lower electrode layer 2, since the oxygen concentration is lower in the surface portion on the lower electrode layer 2 side of the first semiconductor layer 3. As a result, positive holes can be sufficiently moved from the first semiconductor layer 3 to the lower electrode layer 2.

Regarding the first semiconductor layer 3, it is at least desired that the atomic concentration of the oxygen element in the surface portion on the lower electrode layer 2 side is lower than the atomic concentration of the oxygen element in the central portion, in a case where the first semiconductor layer 3 is assumed to be divided into the surface portion on the lower electrode layer 2 side, the central portion, and the surface portion on the second semiconductor layer 4 side by being trisected in the thickness direction (Z-axis direction).

The atomic concentration of the oxygen element is acquired, for example, by measuring the oxygen concentration with energy dispersive X-ray spectroscopy (EDS) in the cross sections of the above-described respective trisected layers. Alternatively, the atomic concentration of the oxygen element may be measured using secondary ion mass spectroscopy (SIMS) while the first semiconductor layer 3 is cut in the depth direction by sputtering.

From a viewpoint of improving the photoelectric conversion efficiency, the atomic concentration of the oxygen element in the central portion of the first semiconductor layer 3 may be, for example, in the range of 1x10²⁰ atoms/cm³ to 1x10²² atoms/cm³, and more preferably in the range of 2x10²⁰ atoms/cm³ to 3x10²¹ atoms/cm³. Further, the atomic concentration of the oxygen element in the surface portion on the lower electrode layer 2 side may be 0.1 times to 0.9 times of the atomic concentration of the oxygen element in the central portion, and more preferably 0.1 times to 0.5 times thereof.

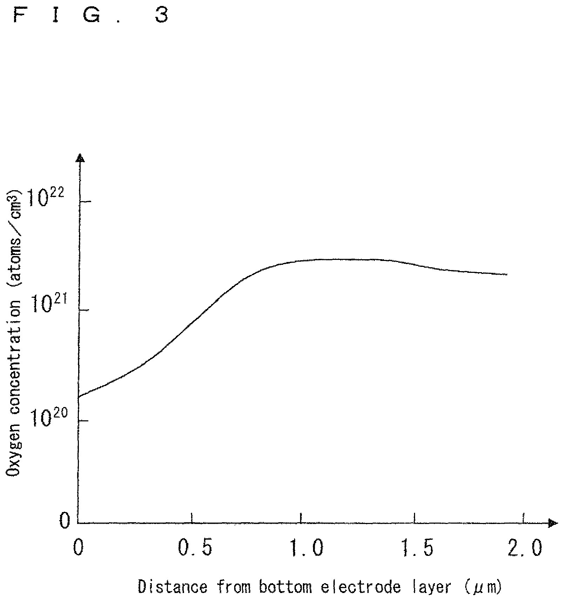

From a viewpoint of improving charge movement in the first semiconductor layer 3, the atomic concentration of the oxygen element in the first semiconductor layer 3 may gradually become lower toward the lower electrode layer 2 from the central portion. For example, Fig. 3 illustrates an example of distribution of the atomic concentration of the oxygen element in the first semiconductor layer 3 in the thickness direction. In Fig. 3, the distribution of the atomic concentration of the oxygen element was measured using SIMS while the first semiconductor layer 3 was cut in the depth direction by sputtering, and the horizontal axis represents a distance from the lower electrode layer 2 and the vertical axis represents the atomic concentration of the oxygen element.

Moreover, in a case where the first semiconductor layer 3 contains an indium element and a gallium element as in the case of CIGS or the like, a ratio of the atomic concentration of the gallium element to the total of the indium element and the gallium element (M_{Ga}/ (M_{Ga}+M_{In})) may be larger in the surface portion on the lower electrode layer 2 side than in the central portion of the first semiconductor layer 3. In this case, the position of energy in a conduction band of the first semiconductor layer 3 can be shifted to the negative potential side in the vicinity of the lower electrode layer 2. As a result, movement of electrons from the first semiconductor layer 3 to the second semiconductor layer 4 can be improved. Accordingly, the photoelectric conversion efficiency of the photoelectric conversion device 11 is further improved. Note that, in M_{Ga}/(M_{Ga}+M_{In}), M_{Ga} represents the atomic concentration of the gallium element and M_{In} represents the atomic concentration of the indium element.

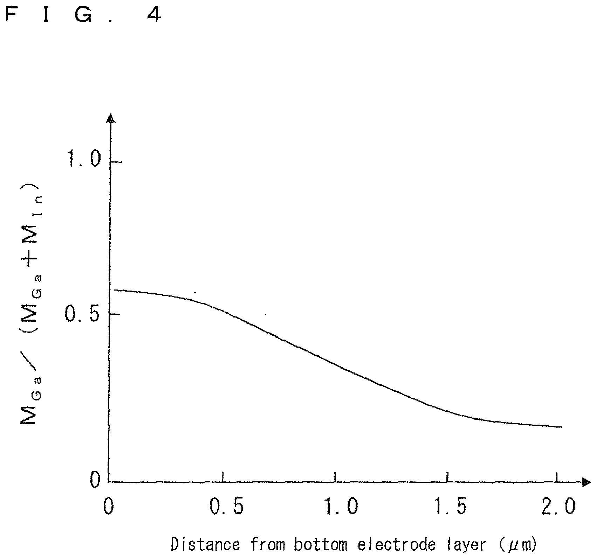

In this case, when the ratio of the atomic concentration of the gallium element to the total of the indium element and the gallium element (M_{Ga}/ (M_{Ga}+M_{In})) gradually becomes larger toward the lower electrode layer 2 from the central portion of the first semiconductor layer 3, movement of charges in the first semiconductor layer 3 is further improved. For example, Fig. 4 illustrates an example of the distribution of the atomic concentration ratio of the gallium element to the total of the indium element and the gallium element in the first semiconductor layer 3 in the thickness direction. In Fig. 4, the horizontal axis represents a distance from the lower electrode layer 2 and the vertical axis represents M_{Ga}/ (M_{Ga}+M_{In}).

The first semiconductor layer 3 whose ratio of the atomic concentration (M_{Ga}/ (M_{Ga}+M_{In})) is different in the thickness direction can be produced by laminating coating films using a raw material whose ratio of concentration of the indium element to the gallium element is changed.

The second semiconductor layer 4 is a semiconductor layer of a second conductivity type which is different from the conductivity type of the first semiconductor layer 3. By electrically connecting the first semiconductor layer 3 and the second semiconductor layer 4, a photoelectric conversion layer with which charges are extracted well is formed. For example, in a case where the first semiconductor layer 3 is a p-type semiconductor layer, the second semiconductor layer 4 is an n-type semiconductor layer. The first semiconductor layer 3 may be an n-type semiconductor layer and the second semiconductor layer 4 may be a p-type semiconductor layer. Further, the second semiconductor layer 4 may be formed of a plurality of layers and at least one of the plurality of layers may be a high-resistance layer.

Examples of materials of the second semiconductor layer 4 include CdS, ZnS, ZnO, In₂S₃, In₂Se₃, In(OH, S), (Zn,In)(Se,OH), (Zn, Mg)O, and the like. The second semiconductor layer 4 is formed to have a thickness of 10 nm to 200 nm using, for example, a chemical bath deposition (CBD) method or the like. In addition, In(OH,S) means a mixed crystal compound containing In as a hydroxide and a sulfide. (Zn,In)(Se,OH) is a mixed crystal compound containing Zn and In as a selenide and a hydroxide. (Zn, Mg)O is a compound containing Zn and Mg as an oxide.

As illustrated in Figs. 1 and 2, the upper electrode layer 5 may be further disposed on the second semiconductor layer 4. The upper electrode layer 5 is a layer with resistivity lower than that of the second semiconductor layer 4 and with which charges generated in the first semiconductor layer 3 and the second semiconductor layer 4 can be extracted well. From a viewpoint of further improving photoelectric conversion efficiency, the resistivity of the upper electrode layer 5 may be lower than 1 Ω·cm and the sheet resistance thereof may be equal to or lower than 50 Ω/□.

The upper electrode layer 5 is a transparent conductive film having a thickness of 0.05 µm to 3 µm made of ITO, ZnO, or the like, for example. For improving translucency and conductivity, the upper electrode layer 5 may be formed of a semiconductor having the same conductivity type as that of the second semiconductor layer 4. The upper electrode layer 5 may be formed by a sputtering method, a evaporation method, a chemical vapor deposition (CVD) method, or the like.

Further, as illustrated in Figs. 1 and 2, a collector electrode 8 may be further formed on the upper electrode layer 5. The collector electrode 8 is an electrode for further efficiently extracting charges generated in the first semiconductor layer 3 and the second semiconductor layer 4. The collector electrode 8 is formed, for example, linearly from one end of the photoelectric conversion cell 10 to the connection conductor 7 as illustrated in Fig. 1. Accordingly, the current generated in the first semiconductor layer 3 and the second semiconductor layer 4 is collected in the collector electrode 8 through the upper electrode layer 5, and is efficiently passed to the adjacent photoelectric conversion cells 10 through the connection conductor 7.

The collector electrode 8 may have a width of 50 µm to 400 µm from a viewpoint of improving light transmittance to the first semiconductor layer 3 and having good conductivity. Further, the collector electrode 8 may include a plurality of branched portions.

The collector electrode 8 is formed by, for example, preparing a metal paste which is obtained by dispersing metal powder such as Ag powder in a resin binder or the like, printing the metal paste into a pattern shape, and curing the metal paste.

In Figs. 1 and 2, the connection conductor 7 is a conductor disposed in a groove penetrating (dividing) the first semiconductor layer 3, the second semiconductor layer 4, and the upper electrode layer 5. A metal, a conductive paste, or the like can be used for the connection conductor 7. In Figs. 1 and 2, the connection conductor 7 is formed by extending the collector electrode 8, but not limited thereto. For example, the connection conductor 7 may be formed by extending the upper electrode layer 5.

### <Method for producing photoelectric conversion device>

Next, a method for producing the photoelectric conversion device 11 having the above-described configuration will be described. Here, a case in which the first semiconductor layer 3 is made of CIGS will be described. First, the lower electrode layer 2, which is formed of Mo or the like, is formed into a desired pattern using a sputtering method or the like on a main surface of the substrate 1 formed of glass or the like.

In addition, using a coating method or the like, a first coating film is formed by coating the lower electrode layer 2 with a film of a raw material solution formed by metal elements (Cu, In, and Ga), which constitute the group I-III-VI compound (CIGS), being dissolved in a solvent, as an organic complex or an organic acid salt. Further, in an atmosphere containing oxygen or water, the first coating film is heated at, for example, 150°C to 350°C, and consequently an organic component in the first coating film is thermally decomposed. During the thermal decomposition, part of the metal element in the first coating film is oxidized (hereinafter, a process of forming the first coating film and thermally decomposing the organic component is referred to as a first process).

Next, a second coating film is formed on the thermally decomposed first coating film using the above-described raw material solution. In addition, the second coating film is heated in an atmosphere containing water or oxygen with a concentration higher than that of the first process, and consequently an organic component in the second coating film is thermally decomposed. Accordingly, the oxygen concentration of the second coating film is higher than that of the first coating film.

Subsequently, a third coating film is formed on the thermally decomposed second coating film using the above-described raw material solution. Further, the third coating film is heated in an atmosphere containing water or oxygen, and consequently an organic component in the third coating film is thermally decomposed.

A laminate including three layers of coating films whose oxygen concentration is lower on the lower electrode layer 2 side than in the central portion in the thickness direction is formed by the above-described process. Further, although three layers are formed herein, two or four or more layers may be formed. The oxygen concentration of the respective layers can be adjusted by changing the concentration of water or oxygen in an atmosphere at the time of thermal decomposition, as described above.

Next, the laminate with the coating films is heated at, for example, 500°C to 600°C in an atmosphere containing a chalcogen element. Accordingly, although a crystal of the group I-III-VI compound (CIGS) is generated while oxygen in the coating films is substituted with the chalcogen element, some oxygen existing in the coating films remains. Since the probability of oxygen remaining in the coating films depends on the concentration of oxygen contained in the coating films, there is a tendency that CIGS having a higher oxygen concentration is generated from the second coating film having a high oxygen concentration as compared with the first coating film. As a result, the first semiconductor layer 3 which contains CIGS and oxygen and whose atomic concentration of oxygen is lower in the surface portion on the lower electrode layer 2 side than in the central portion in the thickness direction is generated.

After the first semiconductor layer 3 is formed, the second semiconductor layer 4 and the upper electrode layer 5 are sequentially formed on the first semiconductor layer 3 using a CBD method, a sputtering method, or the like. In addition, the first semiconductor layer 3, the second semiconductor layer 4, and the upper electrode layer 5 are processed through a mechanical scribing process or the like and consequently a groove for the connection conductor 7 is formed.

Thereafter, for example, conductive paste, which is obtained by dispersing metal powder such as Ag powder in a resin binder or the like, is printed in a pattern shape on the upper electrode layer 5 and in the groove, and the collector electrode 8 and the connection conductor 7 are formed by heating and curing the printed conductive paste.

Finally, the first semiconductor layer 3 to the collector electrode 8 are removed at a position shifted from the connection conductor 7 through a mechanical scribing process so as to provide a plurality of photoelectric conversion cells 10 being divided, thereby obtaining the photoelectric conversion device 11 illustrated in Figs. 1 and 2.

Note that, the present invention is not limited to the above-described embodiment, and various changes and modifications are possible without departing from the scope of the present invention.

### EXAMPLE

Next, a photoelectric conversion device 11 according to an embodiment of the invention will be described with a specific example.

### (Preparation of evaluation sample)

First, a raw material solution for forming a first semiconductor layer 3 was prepared. As the raw material solution, a solution obtained by dissolving a single source precursor which was prepared based on US Patent No. 6992202 in pyridine was used. Further, as the single source precursor, a mixture of one in which a complex molecule is formed of Cu, In, and phenylselenol and one in which a complex molecule is formed of Cu, Ga, and phenylselenol was used.

Subsequently, a substrate 1 formed of glass with the surface which is coated with a lower electrode layer 2 formed of Mo was prepared, and a first coating film was formed by coating the lower electrode layer 2 with the raw material solution using a blade method. In addition, in an atmosphere in which water (water vapor) of 140 ppmv was contained in nitrogen gas at a partial pressure ratio, the first coating film was heated at 280°C for 10 minutes and consequently the organic components contained in the first coating film were thermally decomposed.

Next, a second coating film was formed by coating the thermally decomposed first coating film with the raw material solution using the blade method. In addition, in an atmosphere in which water (water vapor) of 200 ppmv was contained in nitrogen gas at the partial pressure ratio, the second coating film was heated at 280°C for 10 minutes and consequently the organic components contained in the second coating film were thermally decomposed.

Next, a third coating film was formed by coating the thermally decomposed second coating film with the raw material solution using the blade method. In addition, in an atmosphere in which water (water vapor) of 200 ppmv was contained in nitrogen gas at the partial pressure ratio, the third coating film was heated at 280°C for 10 minutes and consequently the organic components contained in the third coating film were thermally decomposed.

Subsequently, in an atmosphere in which selenium vapor of 60 ppmv is contained in hydrogen gas at the partial pressure ratio, the laminate of the first coating film, the second coating film, and the third coating film was heated at 550°C for 1 hour, and consequently the first semiconductor layer 3 mainly containing CIGS and having a thickness of 2 µm was formed.

A second semiconductor layer 4 containing In₂S₃ and having a thickness of 50 nm was formed on the first semiconductor layer 3 by immersing the substrate, on which layers up to the first semiconductor layer 3 are formed, in an aqueous solution in which indium chloride and thioacetamide were dissolved.

Moreover, an upper electrode layer 5 formed of AZO was formed on the second semiconductor layer 4 with a sputtering method to obtain the photoelectric conversion device 11 serving as an evaluation sample.

The distribution of the oxygen element in the first semiconductor layer 3 was measured by performing SIMS measurement while the first semiconductor layer 3 of the evaluation sample prepared as described above was etched in the thickness direction. The result is illustrated in Fig. 3. It was understood that the oxygen concentration was lower in the surface portion on the lower electrode layer 2 side than in the central portion of the first semiconductor layer 3 in the thickness direction.

### (Preparation of comparative sample)

Next, a comparative sample was prepared. The comparative sample was prepared in the same manner as that of the evaluation sample except the formation of the first semiconductor layer. In the formation of the first semiconductor layer of the comparative sample, thermal decomposition of the first to third coating films was performed in an atmosphere free from water and respective layers were thermally decomposed under the same conditions. That is, in the process of thermal decomposition performed on each of the first to third coating films, respective coating films were heated at 280°C for 10 minutes in a nitrogen gas atmosphere and consequently the organic components contained in respective coating films were thermally decomposed.

The distribution of the oxygen element in the first semiconductor layer was measured by performing SIMS measurement while the first semiconductor layer of the comparative sample prepared as described above was etched in the thickness direction. As a result, in the comparative sample, only a trace amount of the oxygen element was contained and a difference in concentration of the oxygen element in the thickness direction of the first semiconductor layer was not observed.

### (Measurement of photoelectric conversion efficiency)

The photoelectric conversion efficiency of the evaluation sample and the comparative sample prepared in the above-described manner was measured as follows. The photoelectric conversion efficiency was measured using a so-called stationary light solar simulator under the condition that irradiation intensity of light with respect to a light receiving surface of the photoelectric conversion device was 100 mW/cm² and AM (air mass) was 1.5. As a result, the photoelectric conversion efficiency of the evaluation sample was 12.8% while the photoelectric conversion efficiency of the comparative sample was 10.0%, and therefore, it was understood that the photoelectric conversion efficiency of the evaluation sample was higher than that of the comparative sample.

### Reference Signs List

- 1: SUBSTRATE
- 2, 2a, 2b, 2c: LOWER ELECTRODE LAYER
- 3: FIRST SEMICONDUCTOR LAYER
- 4: SECOND SEMICONDUCTOR LAYER
- 7: CONNECTION CONDUCTOR
- 10: PHOTOELECTRIC CONVERSION CELL
- 11: PHOTOELECTRIC CONVERSION DEVICE

According to an embodiment, a photoelectric conversion device comprises:
an electrode layer;
a first semiconductor layer disposed on the electrode layer and including a group I-III-VI compound; and
a second semiconductor layer disposed on the first semiconductor layer and forming a pn junction with the first semiconductor layer,
wherein the first semiconductor layer includes at least one of sulfur, selenium, and tellurium as group VI-B elements and oxygen, and
wherein an atomic concentration of oxygen in the first semiconductor layer is lower in a surface portion on the electrode layer side than in a central portion of the first semiconductor layer in a thickness direction thereof.

E.g., in the said photoelectric conversion device, the atomic concentration of oxygen in the first semiconductor layer gradually becomes lower toward the electrode layer from the central portion.

E.g., in the said photoelectric conversion device, the first semiconductor layer includes indium and gallium as group III-B elements, and a ratio of atomic concentration of gallium to the total of indium and gallium is higher in the surface portion on the electrode layer side than in the central portion.

E.g., in the said photoelectric conversion device, the ratio of atomic concentration of gallium to the total of indium and gallium gradually becomes higher toward the electrode layer from the central portion.

## Claims

1. A photoelectric conversion device, comprising:
an electrode layer;
a first semiconductor layer disposed on the electrode layer and including a group I-III-VI compound; and
a second semiconductor layer disposed on the first semiconductor layer and forming a pn junction with the first semiconductor layer,
wherein the first semiconductor layer includes at least one of sulfur, selenium, and tellurium as group VI-B elements, oxygen, indium, and gallium,
wherein an atomic concentration of oxygen in a central portion of the first semiconductor layer in a thickness direction is in the range of l xI0²⁰ atoms/cm³ to lx10²² atoms/cm³, and
wherein a ratio of atomic concentration of gallium to the total of indium and gallium is higher in a surface portion on the electrode layer side of the first semiconductor layer than in the central portion.

2. The photoelectric conversion device according to claim 1,
wherein the ratio of atomic concentration of gallium to the total of indium and gallium gradually becomes higher toward the electrode layer from the central portion of the first semiconductor layer.

3. The photoelectric conversion device according to claim 1 or 2,
wherein the atomic concentration of oxygen in the surface portion on the electrode layer side of the first semiconductor layer is 0.1 times to 0.9 times of the atomic concentration of oxygen in the central portion.
